# DEMANDE DE BREVET EUROPEEN

(11) **EP 2 511 809 A1**
(43) Date de publication de la demande: **17.10.2012**
(21) Numéro de dépôt: 12164097.3
(22) Date de dépôt: 13.04.2012
(51) Int. Cl.: G06F 3/044, H03K 17/96

(54) **Procédé de fabrication d'un capteur tactile capacitif**

(30) Priorité: 15.04.2011 FR 1153304
(71) Demandeur: Nief Plastic, 69740 Genas (FR)
(72) Inventeur: Girodon, Marlène, 69740 Genas (FR); Martin, Thierry, 01050 Montceaux (FR)
(74) Mandataire: Thibault, Jean-Marc

(57) **Abrégé**

L'invention concerne un procédé de fabrication d'un capteur tactile capacitif (1) comportant les étapes suivantes :
- réaliser au moins une électrode de détection (4) en un matériau conducteur électrique, sur un substrat isolant électriquement (3) de sorte que le capteur présente une surface tactile,
- relier l'électrode (4) à un circuit de détection (5) de la capacitance de l'électrode.

Selon l'invention, le procédé consiste pour réaliser l'électrode (4), à surmouler sur un substrat tridimensionnel (3) rigide, un polymère thermoplastique possédant une conductivité électrique supérieure ou égale à 500 S/cm et comportant de 80 à 90 % de charges conductrices métalliques par rapport à la masse totale, afin de réaliser au moins une électrode surmoulée de forme tridimensionnelle, rigide de dureté au moins égale à 80 Shore D.

## Description

La présente invention concerne le domaine technique des interfaces homme-machine et elle vise plus précisément le domaine technique de la fabrication de capteurs tactiles capacitifs.

Les capteurs capacitifs ou capteurs tactiles permettent de détecter si une personne touche ou effleure un objet au sens général. De tels capteurs comportent une ou plusieurs électrodes reliées à un circuit de détection de la capacitance de la ou des électrodes. Lorsqu'une personne touche ou effleure l'électrode, la capacitance de l'électrode change et se trouve détectée par le circuit de détection qui est apte à délivrer un signal de sortie transmis à tout dispositif ou appareil électrique ou électronique dans le domaine de la commande ou de l'affichage par exemple.

Dans l'état de la technique, de nombreuses réalisations de capteurs capacitifs et tactiles ont été proposés par exemple, par les brevets US 5 432 671, US 7 812 825 ou EP 1 381 110.

De manière générale, un tel capteur capacitif présente une surface bidimensionnelle que touche un utilisateur ou sur laquelle l'utilisateur déplace un ou plusieurs doigts pour permettre le fonctionnement du dispositif associé. Tel est le cas par exemple de la demande de brevet US 2010/0013499. Cependant, pour diverses applications il apparaît souhaitable voire nécessaire que l'utilisateur touche une surface tridimensionnelle ou déplace ses doigts au-dessus de la surface tridimensionnelle.

Pour tenter de satisfaire ce besoin, la demande de brevet US 2008/0309634 propose de réaliser un objet tridimensionnel comportant une première surface s'étendant selon un plan en deux dimensions et une seconde surface s'étendant selon un plan en deux dimensions, différent du plan en deux dimensions de la première surface. Cet objet comporte une surface sensitive constituée sur au moins une partie des deux surfaces bidimensionnelles. Chaque surface comporte une ou plusieurs électrodes portées par exemple par un circuit flexible fixé sur l'objet à instrumenter. Une autre solution consiste à réaliser les électrodes directement sur l'objet par les techniques classiques de photogravure.

La demande de brevet US 2005/0041375 décrit un capteur capacitif comportant deux conducteurs électriques réalisés en un matériau polymère incluant en particulier des élastomères thermoplastiques et des charges conductrices électriques. Ces deux conducteurs électriques sont aménagés sur un support isolant électrique réalisé en un matériau polymère. Un tel capteur présente une capacité de flexion pour permettre de suivre un contour en trois dimensions.

La demande de brevet WO 2009/134727 décrit une touche capacitive comportant un premier et un deuxième conducteurs électriques isolés électriquement entre eux et agencés sous la forme de colonnes et de rangées. De tels conducteurs électriques sont réalisés par une encre ou un métal déposé sur un circuit flexible.

En pratique, il apparaît une difficulté certaine à fixer sur l'objet le capteur tactile réalisé sous la forme d'un circuit flexible. Par ailleurs, ces techniques de fabrication sont limitées en ce qui concerne la forme tridimensionnelle pouvant être conférée au capteur tactile.

La présente invention vise à remédier aux inconvénients de l'état de la technique en proposant un procédé de fabrication permettant de réaliser de manière simple et peu coûteuse, un capteur tactile capacitif présentant des formes tridimensionnelles diversifiées et adaptées à l'utilisation et ne posant pas de problème de fixation ou de montage par rapport à l'objet auquel il doit être associé.

Un autre objet de l'invention est de proposer un procédé de fabrication permettant de réaliser un capteur possédant une conductivité électrique relativement élevée pour autoriser sa mise en oeuvre dans de nombreuses applications.

Pour atteindre un tel objectif, le procédé selon l'invention concerne un procédé de fabrication d'un capteur tactile capacitif comportant les étapes suivantes :
- réaliser au moins une électrode de détection en un matériau conducteur électrique, sur un substrat isolant électriquement de sorte que le capteur présente une surface tactile,
- relier l'électrode à un circuit de détection de la capacitance de l'électrode.

Selon l'invention, le procédé consiste pour réaliser l'électrode, à surmouler sur un substrat tridimensionnel rigide, un polymère thermoplastique, ayant une conductivité électrique supérieure ou égale à 500 S/cm et comportant de 80 à 90 % de charges conductrices métalliques par rapport à la masse totale, afin de réaliser au moins une électrode surmoulée de forme tridimensionnelle rigide possédant une dureté supérieure ou égale à 80 Shore D.

De plus, le procédé selon l'invention peut présenter en outre en combinaison au moins l'une et/ou l'autre des caractéristiques additionnelles suivantes :
- réaliser la surface tactile sur le substrat tridimensionnel isolant électriquement ou sur l'électrode,
- recouvrir l'électrode par une peau de contact isolante électriquement pour servir de surface tactile,
- surmouler en tant que polymère thermoplastique fortement conducteur, un polymère ou mélange de polymères appartenant aux familles des polyamides (PA), des polysulfures de phénylène (PPS), des polybutylènes téréphtalates (PBT), des polymères à cristaux liquides (LCP), etc.,
- surmouler un polymère thermoplastique possédant une conductivité électrique comprise entre 1000 et 5000 S/cm,
- surmouler le polymère thermoplastique avec des charges conductrices électriques comportant des fibres métalliques présentant une longueur prise dans la gamme allant de 100 µm à 10 mm, et/ou des poudres métalliques présentant un diamètre pris dans la gamme allant de 10 µm à 500 µm,
- surmouler le polymère thermoplastique sur le substrat isolant en effectuant une opération de thermoformage, d'injection ou de compression,
- former au moins deux électrodes séparées électriquement entre elles et réalisées de manière complémentaire pour assurer une variation progressive de la capacitance,
- réaliser chaque électrode avec une épaisseur comprise entre 1 et 5 mm et de préférence de l'ordre de 2 mm.

Un autre objet de l'invention est de proposer un capteur tactile capacitif comportant au moins une électrode de détection supportée par un substrat isolant électriquement et reliée à un circuit de détection de la capacitance de l'électrode.

Selon l'invention, l'électrode de détection est une électrode rigide de forme tridimensionnelle surmoulée sur le substrat tridimensionnel, en un polymère thermoplastique comportant de 80 à 90 % de charges métalliques par rapport à la masse totale.

De plus, le capteur selon l'invention peut présenter en outre en combinaison au moins l'une et/ou l'autre des caractéristiques additionnelles suivantes :
- l'électrode de détection est une électrode de forme tridimensionnelle surmoulée sur le substrat tridimensionnel, en un polymère thermoplastique comportant des fibres métalliques présentant une longueur prise dans la gamme allant de 100 µm à 10 mm, et/ou des poudres métalliques présentant un diamètre pris dans la gamme allant de 10 µm à 500 µm,
- le capteur est susceptible d'être obtenu par le procédé de fabrication.

Un autre objet de l'invention est de proposer un objet comportant au moins un capteur tactile capacitif tridimensionnel.

Diverses autres caractéristiques ressortent de la description faite ci-dessous en référence aux dessins annexés qui montrent, à titre d'exemples non limitatifs, des formes de réalisation de l'objet de l'invention.
La **Figure 1** est une vue en perspective d'un exemple de réalisation d'un capteur tactile capacitif conforme à l'invention.
La **Figure 2** est une vue à l'envers en position démontée d'un capteur tactile capacitif conforme à l'invention.
La **Figure 3** est une vue en coupe élévation du capteur illustré aux **Fig. 1** et **2****.**
La **Figure 4** est une vue en coupe montrant un autre exemple de réalisation d'un capteur conforme à l'invention.
La **Figure 5** est une vue en coupe d'un autre exemple de réalisation d'un capteur conforme à l'invention revêtu d'une peau de protection.

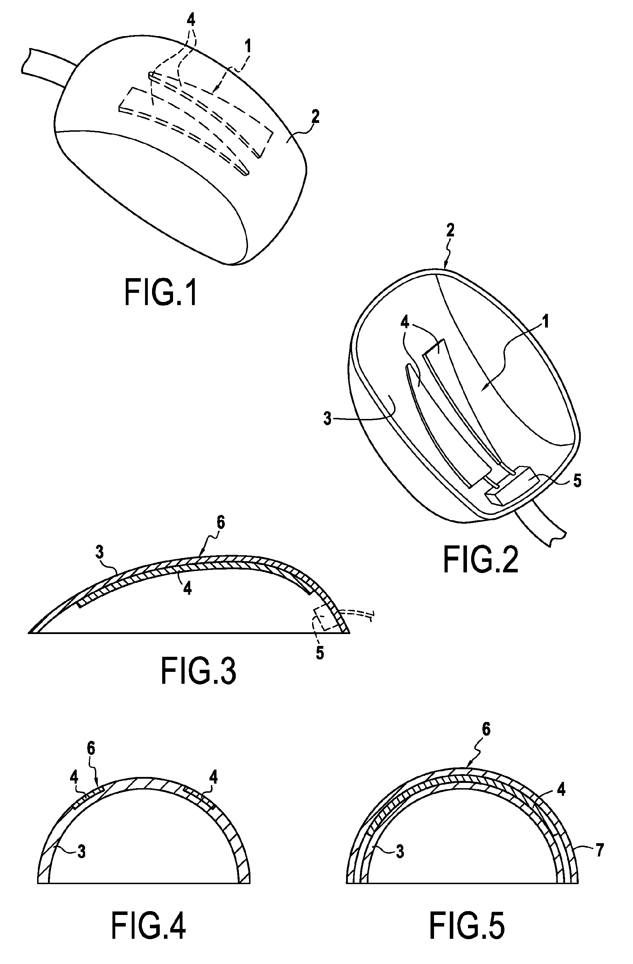

L'objet de l'invention vise un procédé pour fabriquer un capteur tactile capacitif **1** de forme tridimensionnelle. Comme cela sera expliqué dans la suite de la description, la fabrication du capteur tactile capacitif **1** est directement associé à la fabrication de tout ou partie d'un objet **2** auquel le capteur tactile capacitif **1** est associé. Dans l'exemple illustré aux **Fig. 1** à **3****,** le capteur tactile capacitif **1** est associé à un objet **2** se présentant sous la forme d'une souris informatique. Bien entendu, le capteur tactile capacitif **1** peut être intégré ou associé afin de constituer différents types d'objets tels que manette de commande, télécommande, écran, téléphone, instrument de musique, poignée d'appareil sportif, tableau de commande intégré ou déporté pour planche de bord d'un véhicule, électroménager, etc..

Le procédé selon l'invention consiste à réaliser un substrat **3** rigide, isolant électriquement et présentant une forme tridimensionnelle. Conformément à l'invention, le procédé consiste à surmouler sur le substrat rigide **3,** au moins une électrode de détection **4** de forme tridimensionnelle réalisée en un matériau polymère thermoplastique comportant des charges conductrices électriques. L'électrode de détection **4** obtenue par surmoulage est rigide et possède à cet effet une dureté Shore D au moins égale à 80 Shore D. Dans l'exemple illustré aux **Fig. 1** à **3****,** deux électrodes de détection **4** sont surmoulées sur le substrat **3.**

Le procédé selon l'invention consiste à relier électriquement les électrodes **4** à un circuit **5** de détection de la capacitance des électrodes **4.**

Il doit être considéré que le capteur **1** ainsi réalisé présente une surface tactile **6** dont le toucher ou l'effleurement conduit à une variation de la capacitance de l'électrode qui est détectée par l'intermédiaire du circuit **5.** Le circuit de détection **5** permet ainsi de délivrer un signal de sortie exploité par tout système ou dispositif électronique associé à l'objet **2.** Le circuit de détection **5** et le système ou dispositif électronique associé ne sont pas décrits précisément car ils ne font pas partie précisément de l'objet de l'invention et sont bien connus de l'homme du métier.

Dans l'exemple illustré aux **Fig. 1** et **3****,** la surface tactile **6** correspond à une partie du substrat **3** située en relation ou en vis-à-vis des électrodes **4.**

Dans l'exemple de réalisation illustré à la **Fig. 4****,** la surface tactile **6** correspond à tout ou partie de la surface des électrodes.

Dans l'exemple de réalisation illustré de la **Fig. 5****,** la surface tactile **6** correspond à une partie d'une peau de contact isolante électriquement **7** recouvrant l'électrode **4.** La peau de contact isolante électriquement **7** est située à l'opposé du substrat isolant **3.**

A titre d'exemple, cette peau de contact isolante électriquement **7** est réalisée par tous moyens appropriés tels que par compression, injection, thermoformage ou dépôt. Par exemple, cette peau de contact **7** peut être un vernis ou une couche de polymère par exemple.

Il est à noter que la surface tactile **6** peut être délimitée par un marquage, afin que l'utilisateur puisse le repérer plus facilement.

Il ressort de la description qui précède que la fabrication du capteur tactile capacitif **1** conduit à la fabrication de tout ou partie de l'objet **2.** En effet, le substrat **3** peut constituer tout ou partie de l'objet **2.** Dans les exemples illustrés aux **Fig. 1** à **4****,** le substrat **3** forme une partie du boîtier ou de la coque de l'objet **2.** Le substrat **3** est réalisé en tout matériau rigide isolant électriquement. Par exemple, le matériau constitutif du substrat **3** est un polymère ou un mélange de polymères appartenant aux familles des polypropylènes, des polyamides, des polyéthylènes, des polysulfures de phénylène, des polybutylènes téréphtalates, etc.. Le substrat **3** est réalisé par exemple par les techniques de moulage. Le substrat **3** peut présenter des formes tridimensionnelles très diversifiées en fonction de la nature ou de l'application de l'objet **2.**

Selon une première variante de réalisation, le procédé selon l'invention consiste à surmouler sur le substrat **3** en tant que polymère thermoplastique fortement conducteur pour réaliser le ou les électrodes **4,** un polymère ou mélange de polymères appartenant aux familles des polyamides (PA), des polysulfures de phénylène (PPS), des polybutylènes téréphtalates (PBT), des polymères à cristaux liquides (LCP), etc..

Selon une autre caractéristique de l'invention, le procédé de fabrication consiste à surmouler un polymère thermoplastique comportant en tant que charges conductrices électriques, de 80 à 90 % de charges métalliques par rapport à la masse totale (polymère(s) + charges). Par exemple de telles charges métalliques sont en cuivre, étain, fer, argent, nickel, aluminium etc.. Selon une autre caractéristique de l'invention, les charges conductrices électriques présentent une taille déterminée pour permettre l'opération de surmoulage. D'une manière générale, les charges conductrices électriques se présentent sous la forme de fibres et/ou de particules plus ou moins sphériques. Ainsi, les charges conductrices électriques comportent des fibres métalliques et/ou des poudres métalliques. Avantageusement, les fibres métalliques présentent une longueur prise dans la gamme allant de 100 µm à 10 mm. Avantageusement, les poudres métalliques présentent un diamètre pris dans la gamme allant de 10 µm à 500 µm.

Le procédé de fabrication selon l'invention consiste à surmouler le polymère thermoplastique sur le substrat isolant **3** en effectuant une opération de thermoformage, d'injection ou de compression. Par exemple, il peut être envisagé de réaliser l'injection d'une matrice thermoplastique de nature PA6 chargée de 80 % en masse de charges métalliques comportant des particules métalliques du type cuivre, étain et des fibres métalliques. A titre d'exemple, il peut être surmoulé le polymère thermoplastique commercialisé par la Société A. SCHULMAN S.A.S. (FR) sous la dénomination SCHULATEC^{®} Tin CO 50 Naturel. Les paramètres d'injection sont les suivants :
- diamètre de vis : 35 mm
- température d'adaptation : 300°C
- température de moule : 80°C
- pression de commutation : 1 000 bars
- pression de maintien : 300 bars

Avantageusement, chaque électrode **4** présente une épaisseur comprise entre 1 et 5 mm et de préférence de l'ordre de 2 mm. (L'opération de surmoulage du polymère thermoplastique permet de réaliser les électrodes **4** selon des formes tridimensionnelles très diversifiées, en épousant la forme du substrat **3.** Le surmoulage du polymère thermoplastique sur le substrat **3** permet d'obtenir le montage simple et efficace des électrodes **4** sur le substrat **3** sans nécessiter de moyens d'assemblage supplémentaires. En effet, le surmoulage de l'électrode de détection **4** sur le substrat rigide **3** permet d'obtenir une adhésion ou une liaison intime entre le substrat **3** et l'électrode de détection **4.** Il est à noter que l'opération de surmoulage du polymère thermoplastique correspond classiquement à une opération de moulage à chaud d'au moins un polymère thermoplastique sur un substrat.

La technique de surmoulage offre aussi l'avantage de pouvoir conférer aux électrodes **4** toutes les formes souhaitées permises par les process de thermoformage, d'injection ou de compression. Ainsi, il peut être prévu que le capteur **1** comporte une électrode **4** formant une touche possédant toutes formes tridimensionnelles. De même, il peut être envisagé que le capteur **1** comporte plusieurs électrodes **4** réalisées de manière complémentaire pour assurer une variation progressive de la capacitance lors du déplacement du doigt par rapport aux électrodes **4** pour former un slider **(****Fig. 1** à **3****).**

L'invention n'est pas limitée aux exemples décrits et représentés car diverses modifications peuvent y être apportées sans sortir de son cadre.

## Revendications

1. Procédé de fabrication d'un capteur tactile capacitif **(1)** comportant les étapes suivantes :
- réaliser au moins une électrode de détection **(4)** en un matériau conducteur électrique, sur un substrat isolant électriquement **(3)** de sorte que le capteur présente une surface tactile **(6),**
- relier l'électrode **(4)** à un circuit de détection **(5)** de la capacitance de l'électrode,
**caractérisé en ce qu'**il consiste pour réaliser l'électrode **(4),** à surmouler sur un substrat tridimensionnel **(3)** rigide, un polymère thermoplastique possédant une conductivité électrique supérieure ou égale à 500 S/cm et comportant de 80 à 90 % de charges conductrices métalliques par rapport à la masse totale, afin de réaliser au moins une électrode surmoulée de forme tridimensionnelle, rigide de dureté au moins égale à 80 Shore D.

2. Procédé de fabrication selon la revendication 1, **caractérisé en ce qu'**il consiste à réaliser la surface tactile **(6)** sur le substrat tridimensionnel isolant électriquement **(3)** ou sur l'électrode **(4).**

3. Procédé de fabrication selon la revendication 1, **caractérisé en ce qu'**il consiste à recouvrir l'électrode **(4)** par une peau de contact isolante électriquement **(7)** pour servir de surface tactile **(6).**

4. Procédé de fabrication selon la revendication 1, **caractérisé en ce qu'**il consiste à surmouler en tant que polymère thermoplastique, un polymère ou mélange de polymères appartenant aux familles des polyamides (PA), des polysulfures de phénylène (PPS), des polybutylènes téréphtalates (PBT), des polymères à cristaux liquides (LCP),

5. Procédé de fabrication selon la revendication 3 ou 4, **caractérisé en ce qu'**il consiste à surmouler un polymère thermoplastique possédant une conductivité comprise entre 1000 et 5000 S/cm.

6. Procédé de fabrication selon la revendication 1 , **caractérisé en ce qu'**il consiste à surmouler le polymère thermoplastique avec des charges conductrices électriques comportant des fibres métalliques présentant une longueur prise dans la gamme allant de 100 µm à 10 mm, et/ou des poudres métalliques présentant un diamètre pris dans la gamme allant de 10 µm à 500 µm,

7. Procédé de fabrication selon l'une des revendications 1 à 6, **caractérisé en ce qu'**il consiste à surmouler le polymère thermoplastique sur le substrat isolant **(3)** en effectuant une opération de thermoformage, d'injection ou de compression.

8. Procédé de fabrication selon la revendication 1, **caractérisé en ce qu'**il consiste à former au moins deux électrodes **(4)** séparées électriquement entre elles et réalisées de manière complémentaire pour assurer une variation progressive de la capacitance.

9. Procédé de fabrication selon l'une des revendications 1 à 8, **caractérisé en ce qu'**il consiste à réaliser chaque électrode **(4)** avec une épaisseur comprise entre 1 et 5 mm et de préférence de l'ordre de 2 mm.

10. Capteur tactile capacitif comportant au moins une électrode de détection **(4)** supportée par un substrat **(3)** isolant électriquement et reliée à un circuit de détection **(5)** de la capacitance de l'électrode, **caractérisé en ce que** l'électrode de détection **(4)** est une électrode de forme tridimensionnelle surmoulée sur le substrat tridimensionnel **(3),** possédant une dureté au moins égale à 80 Shore D et réalisée en un polymère thermoplastique comportant de 80 à 90 % de charges métalliques conductrices par rapport à la masse totale.

11. Capteur tactile capacitif selon la revendication 10, **caractérisé en ce que** l'électrode de détection **(4)** est une électrode de forme tridimensionnelle surmoulée sur le substrat tridimensionnel **(3),** possédant une conductivité comprise entre 1000 et 5000 S/cm.

12. Capteur tactile capacitif selon la revendication 10 ou 11, **caractérisé en ce que** l'électrode de détection **(4)** est une électrode de forme tridimensionnelle surmoulée sur le substrat tridimensionnel **(3),** en un polymère thermoplastique comportant des fibres métalliques présentant une longueur prise dans la gamme allant de 100 µm à 10 mm, , et/ou des poudres métalliques présentant un diamètre pris dans la gamme allant de 10 µm à 500 µm,

13. Capteur tactile capacitif tridimensionnel susceptible d'être obtenu par le procédé de fabrication conforme à l'une des revendications 1 à 9.

14. Objet comportant au moins un capteur tactile capacitif tridimensionnel conforme à l'une des revendications 10 à 13.
